# FASCICULE DE BREVET EUROPEEN

(11) **EP 3 555 706 B1**
(45) Date de publication et mention de la délivrance du brevet: **27.01.2021**
(21) Numéro de dépôt: 17816648.4
(22) Date de dépôt: 07.12.2017
(51) Int. Cl.: G03F 7/00

(54) **PROCÉDÉ DE FONCTIONNALISATION D'UN SUBSTRAT**
VERFAHREN ZUR FUNKTIONALISIERUNG EINES SUBSTRATS
METHOD FOR FUNCTIONALISING A SUBSTRATE

(30) Priorité: 16.12.2016 FR 1662677
(43) Date de publication de la demande: 23.10.2019
(73) Titulaire: Commissariat à l'Énergie Atomique et aux Énergies Alternatives, 75015 Paris (FR)
(72) Inventeur: LANDIS, Stefan, 38210 Tullins (FR); TIRON, Raluca, 38950 Saint-Martin-le-Vinoux (FR)
(74) Mandataire: Cabinet Camus Lebkiri
(86) Numéro de dépôt international: PCT/EP2017/081908
(87) Numéro de publication internationale: WO 2018/108708

(56) Documents cités:
- EP-A1- 1 576 420
- WO-A1-2012/163702
- US-A1- 2006 046 069
- US-A1- 2012 135 159

## Description

### DOMAINE TECHNIQUE

La présente invention concerne un procédé de fonctionnalisation d'un substrat destiné à l'auto-assemblage d'un copolymère à blocs. La présente invention concerne également un procédé de chémo-épitaxie à partir d'un substrat fonctionnalisé au moyen du procédé de fonctionnalisation.

### ÉTAT DE LA TECHNIQUE

L'auto-assemblage dirigé de copolymères à blocs (DSA, pour « Directed self-assembly » en anglais) est une technique de lithographie émergente permettant de former des motifs de dimension critique inférieure à 30 nm. Cette technique constitue une alternative moins onéreuse à la lithographie Extrême UltraViolet (EUV) et à la lithographie par faisceau d'électrons (« e-beam »).

Les procédés connus d'auto-assemblage de copolymères à blocs peuvent être regroupés en deux catégories, la grapho-épitaxie et la chémo-épitaxie, toutes deux décrites en détail dans l'article ["Guided self-assembly of block-copolymer for CMOS technology: a comparative study between grapho-epitaxy and surface chemical modification", L. Oria et al., SPIE 2011, Vol. 7970-24].

La grapho-épitaxie consiste à former des motifs topographiques primaires appelés guides à la surface d'un substrat, ces motifs délimitant des zones à l'intérieur desquelles une couche de copolymère à blocs est déposée. Les motifs de guidage permettent de contrôler l'organisation des blocs de copolymère pour former des motifs secondaires de plus haute résolution à l'intérieur de ces zones. Les motifs de guidage sont classiquement formés par photolithographie dans une couche de résine, et éventuellement, transférés dans un masque dur.

La chémo-épitaxie consiste à modifier les propriétés chimiques de certaines portions du substrat, pour forcer l'organisation des blocs de copolymère entre ces portions. La modification chimique du substrat peut notamment être obtenue par le greffage d'une couche de fonctionnalisation en polymère. Puis, cette couche de fonctionnalisation est structurée afin de créer un contraste chimique à la surface du substrat. Les portions nues du substrat auront ainsi une première affinité chimique vis-à-vis des blocs du copolymère, tandis que les portions du substrat recouvertes par la couche de fonctionnalisation auront une deuxième affinité chimique, différente de la première affinité chimique. La structuration de la couche de fonctionnalisation est classiquement obtenue par une étape de lithographie optique ou à faisceau d'électrons.

Le document US2012/0135159 décrit un autre procédé de fonctionnalisation d'un substrat, au moyen d'une résine imprimable. Une couche de résine ayant une affinité préférentielle pour l'un des blocs du copolymère est déposée sur un substrat. Cette couche de résine est ensuite imprimée à l'aide d'un moule, de façon à obtenir un contraste topographique au sein même de la couche de résine. Au cours de l'impression, la résine est réticulée, soit par chauffage du moule, soit par exposition à des ultraviolets à travers le moule. Puis, la résine imprimée est traitée chimiquement, par exposition à un plasma d'oxygène, de manière à exposer le substrat dans les motifs imprimés. Cette étape de traitement revient à amincir la couche de résine réticulée pour atteindre une épaisseur inférieure à 10 nm. La couche de résine amincie sert ensuite de couche de fonctionnalisation dans un procédé de chémo-épitaxie.

L'impression thermique ou assistée par ultraviolets mise en œuvre dans le procédé de fonctionnalisation du document US2012/0135159 est une technique alternative à la lithographie à faisceau d'électrons (« e-beam ») pour structurer la couche de fonctionnalisation. Elle évite l'apparition de défauts, due à la superposition de la résine à imprimer (i.e. le polymère de la couche de fonctionnalisation) et d'une résine électro-sensible (i.e. sensible au faisceau d'électrons). Cependant, l'étape de traitement chimique de la résine imprimée - au moyen d'un plasma - a pour effet d'endommager la surface de la couche de fonctionnalisation (sur laquelle est déposé le copolymère à blocs) et de modifier son affinité chimique. Il en résulte que l'affinité chimique dans les zones du substrat recouvertes par la couche de fonctionnalisation est difficilement contrôlable avec un tel procédé.

### RÉSUMÉ DE L'INVENTION

Il existe donc un besoin de prévoir un procédé de fonctionnalisation d'un substrat qui n'endommage pas la couche de fonctionnalisation, ni ne modifie son affinité chimique, afin de garantir de bonnes propriétés lithographiques au procédé ultérieur d'auto-assemblage de copolymère à blocs.

Selon l'invention, on tend à satisfaire ce besoin en prévoyant les étapes suivantes :
- déposer à la surface d'un substrat une couche d'un premier matériau polymère, le premier matériau polymère présentant une première affinité chimique vis-à-vis du copolymère à blocs ;
- greffer une partie seulement de la couche de premier matériau polymère à la surface du substrat ;
- imprimer, à l'aide d'un moule, des motifs dans une couche sacrificielle disposée au-dessus de la partie greffée de la couche de premier matériau polymère ;
- transférer les motifs de la couche sacrificielle dans la partie greffée de la couche en premier matériau polymère, jusqu'à atteindre le substrat ; et
- éliminer au moins une partie de la couche sacrificielle par gravure humide, de façon à découvrir la partie greffée de la couche en premier matériau polymère.

Ainsi, dans ce procédé de fonctionnalisation, la partie greffée de la couche de polymère constitue une couche de fonctionnalisation, qui est structurée par transfert des motifs imprimés préalablement dans la couche sacrificielle. Cette couche sacrificielle permet de protéger les parties utiles de la couche de fonctionnalisation - c'est-à-dire les parties sur lesquelles sera déposé le copolymère à blocs - au cours de la structuration de la couche de fonctionnalisation. En effet, les parties utiles de la couche de fonctionnalisation sont recouvertes par la couche sacrificielle lors de l'étape de transfert des motifs imprimés. Après ce transfert, le retrait de la couche sacrificielle est effectué par un procédé de gravure humide, afin de ne pas endommager la couche de fonctionnalisation sous-jacente ou altérer ses propriétés chimiques.

Le procédé de fonctionnalisation selon l'invention permet donc d'obtenir une couche de fonctionnalisation structurée à la surface du substrat, ayant l'affinité chimique souhaitée ainsi qu'un bon état de surface. À l'inverse, dans le procédé de l'art antérieur, la surface de la couche de fonctionnalisation (constituée d'une résine imprimée puis amincie) est exposée à un plasma d'oxygène qui crée des défauts de surface et modifie son affinité chimique de manière incontrôlée.

Dans un premier mode de mise en œuvre du procédé de fonctionnalisation selon l'invention, la couche sacrificielle est constituée par une partie non-greffée de la couche de premier matériau polymère.

Dans un deuxième mode de mise en œuvre du procédé de fonctionnalisation, la couche sacrificielle est constituée d'un matériau polymère imprimable distinct du premier matériau polymère. Le procédé comprend alors avantageusement une étape consistant à éliminer une partie non-greffée de la couche de premier matériau polymère, puis à déposer la couche sacrificielle en matériau polymère imprimable sur la partie greffée de la couche de premier matériau polymère.

Dans un troisième mode de mise en œuvre du procédé de fonctionnalisation, la couche sacrificielle comporte une première sous-couche constituée par une partie non-greffée de la couche de premier matériau polymère et une deuxième sous-couche en un matériau polymère imprimable distinct du premier matériau polymère, ladite au moins une partie de la couche sacrificielle éliminée par gravure humide correspondant à la première sous-couche. Le procédé comprend alors avantageusement une étape de dépôt de la couche sacrificielle en matériau polymère imprimable sur la partie non-greffée de la couche de premier matériau polymère.

De préférence, le matériau polymère imprimable est une résine thermoplastique, une résine thermodurcissable ou une résine photo-polymérisable.

Selon un développement du procédé de fonctionnalisation, le substrat comporte une couche superficielle en un deuxième matériau polymère présentant une deuxième affinité chimique vis-à-vis du copolymère à blocs et les motifs de la couche sacrificielle sont en outre transférés dans la couche superficielle.

Le procédé selon l'invention peut également présenter une ou plusieurs des caractéristiques ci-dessous, considérées individuellement ou selon toutes les combinaisons techniquement possibles :
- ladite au moins une partie de la couche sacrificielle est éliminée au moyen d'un solvant ;
- le premier matériau polymère est neutre par rapport aux blocs du copolymère à blocs ;
- le deuxième matériau polymère présente une affinité préférentielle pour l'un des blocs du copolymère à blocs ;
- la couche de premier matériau polymère est formée d'un copolymère statistique, d'un homopolymère ou d'une monocouche auto-assemblée ;
- les motifs sont imprimés dans la couche sacrificielle par impression thermique ou par impression assistée par ultraviolets ; et
- le greffage de la couche de premier matériau polymère à la surface du substrat s'effectue en même temps que l'impression des motifs.

L'invention concerne également un procédé de chémo-épitaxie comprenant la préparation d'un substrat fonctionnalisé à l'aide du procédé de fonctionnalisation décrit ci-dessus, le dépôt d'un copolymère à blocs à la surface du substrat fonctionnalisé et l'assemblage du copolymère à blocs.

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
- les figures 1A à 1E représentent des étapes d'un procédé de fonctionnalisation selon un premier mode de mise en œuvre de l'invention ;
- les figures 2A à 2F représentent des étapes d'un procédé de fonctionnalisation selon un deuxième mode de mise en œuvre de l'invention ;
- les figures 3A à 3F représentent des étapes d'un procédé de fonctionnalisation selon un troisième mode de mise en œuvre de l'invention ; et
- les figures 4A à 4E représentent des étapes d'un procédé de fonctionnalisation selon un quatrième mode de mise en œuvre de l'invention.

Pour plus de clarté, les éléments identiques ou similaires sont repérés par des signes de référence identiques sur l'ensemble des figures.

### DESCRIPTION DÉTAILLÉE D'AU MOINS UN MODE DE RÉALISATION

Le procédé de fonctionnalisation objet de l'invention a pour but de créer un contraste chimique à la surface d'un substrat, au moyen d'une couche de fonctionnalisation recouvrant une ou plusieurs zones du substrat. Les zones restantes du substrat peuvent être laissées nues, auquel cas le substrat présente une affinité chimique différente de celle de la couche de fonctionnalisation. Le contraste chimique peut également être obtenu en disposant côte à côte à la surface du substrat des couches de fonctionnalisation ayant des affinités chimiques différentes.

Ce substrat fonctionnalisé est destiné à être recouvert d'un copolymère à blocs, dans le cadre d'un procédé d'auto-assemblage de copolymère à blocs. Le contraste chimique permet de forcer l'organisation des blocs de monomère qui composent le copolymère. Ainsi, les affinités chimiques du substrat et de la (ou des) couche(s) de fonctionnalisation s'entendent par rapport aux blocs du copolymère. Ces affinités peuvent être choisies parmi les possibilités suivantes :
- affinité préférentielle pour l'un quelconque des blocs du copolymère ; ou
- neutre, c'est-à-dire sans préférence pour l'un quelconque des blocs du copolymère.

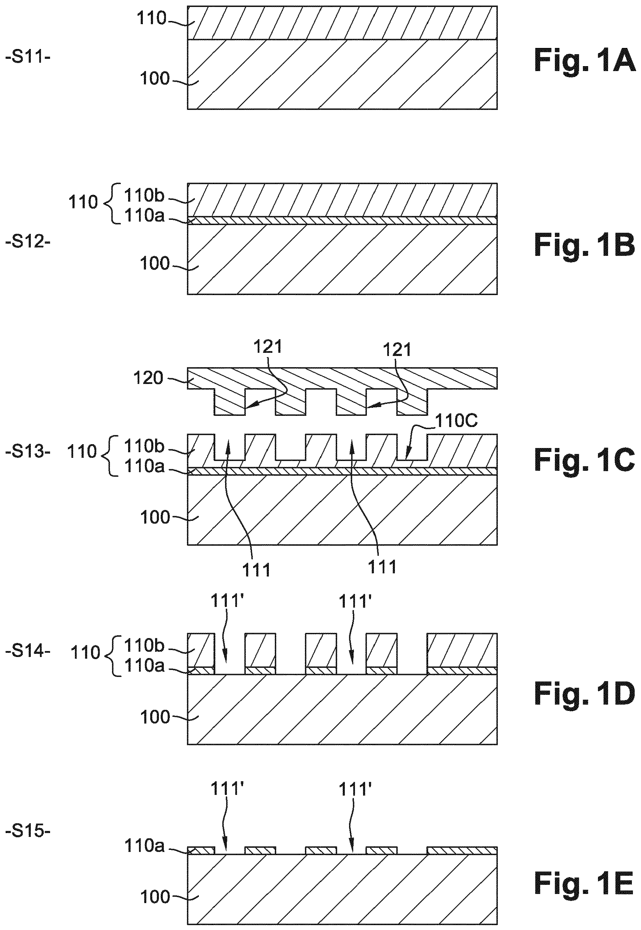

Les figures 1A à 1E représentent des étapes S11 à S15 d'un procédé permettant de fonctionnaliser un substrat 100, d'après un premier mode de mise en œuvre de l'invention.

La première étape S11, illustrée par la figure 1A, consiste à déposer à la surface du substrat 100 une couche d'un matériau polymère 110, appelé polymère de fonctionnalisation. Ce polymère de fonctionnalisation 110, greffable, est choisi en fonction de l'affinité chimique qu'on souhaite donner à certaines zones du substrat 100. En outre, dans ce premier mode de mise en œuvre, le polymère de fonctionnalisation 110 est imprimable, c'est-à-dire qu'il est apte à être structuré, ou modelé, via un procédé d'impression.

Le polymère de fonctionnalisation 110 est de préférence un copolymère statistique, un homopolymère ou tout autre type de polymère greffable (et imprimable) permettant de contrôler l'énergie de surface (l'énergie de surface détermine l'affinité chimique vis-à-vis des blocs du copolymère). La couche de polymère 110 peut être également formée d'une monocouche auto-assemblée (également appelées SAM pour « Self-Assembled Monolayer » en anglais).

De préférence, le polymère de fonctionnalisation 110 est neutre vis-à-vis des blocs du copolymère. Autrement dit, les forces d'interaction entre chacun des blocs du copolymère et le polymère de fonctionnalisation 110 sont équivalentes. À titre d'exemple, lorsque le copolymère à blocs destiné à recouvrir le substrat fonctionnalisé est du PS-b-PMMA de morphologie cylindrique, le polymère de fonctionnalisation 110 peut être du copolymère statistique PS-*r*-PMMA comportant 70% en masse de polystyrène (PS) et 30% en masse de polyméthacrylate de méthyle (PMMA). Lorsque le copolymère à blocs est du PS-*b*-PMMA de morphologie lamellaire, le polymère de fonctionnalisation 110 peut être du PS-*r*-PMMA comportant 50% en masse de PS et 50 % en masse de PMMA.

Le dépôt du polymère de fonctionnalisation 110 sur le substrat 100 est avantageusement effectué par dépôt à la tournette (ou « spin coating » selon le terme anglais). Le polymère de fonctionnalisation 110 est dilué dans un solvant pour former une solution et cette solution est étalée sur le substrat 100, par force centrifuge. Par exemple, lorsque le polymère de fonctionnalisation 110 est du PS-r-PMMA, le solvant peut être de l'acétate d'éther monométhylique de propylène glycol (PGMEA) et la solution peut présenter une concentration massique en polymère d'environ 1,5 %. Après dépôt, la couche de polymère 110 en solution présente généralement une épaisseur comprise entre 5 nm et 100 nm, et de préférence entre 10 nm et 50 nm. Une telle épaisseur permet de disperser du polymère sur toute la surface du substrat.

D'autres modes de dépôt du polymère de fonctionnalisation 110 peuvent être envisagés, par exemple le dépôt par pulvérisation (« spray coating »), le dépôt par goutte (« drop dispense »), le dépôt à la raclette (« blade coating ») et le dépôt chimique en phase vapeur (« Chemical Vapor Deposition »).

Puis, à l'étape S12 de la figure 1B, une partie 110a de la couche de polymère 110 est greffée à la surface du substrat 100. Ce greffage peut être effectué par recuit. En effet, en chauffant la couche de polymère 110 déposée sur le substrat 100, des liaisons covalentes se forment entre une partie des chaînes du polymère et la surface du substrat. Ces chaînes de polymère sont alors intiment liées au substrat 100. Les chaînes de polymère non liées par des liaisons covalentes au substrat sont contenues dans une partie non-greffée 110b de la couche de polymère 110, disposée au-dessus de la partie greffée 110a. Le recuit est par exemple effectué à une température de 250 °C pendant une durée de 10 minutes environ, en disposant le substrat dans un four ou sur une table chauffante. Le solvant est évaporé avant ou pendant le recuit de greffage. L'épaisseur de la partie greffée 110a de la couche de polymère 110 est comprise entre 1 nm et 15 nm. Elle est typiquement de l'ordre de 5 nm.

En référence à la figure 1C, le procédé de fonctionnalisation comporte ensuite une étape S13 d'impression de motifs en creux 111 dans la partie non-greffée 110b de la couche de polymère 110. Un moule 120 comprenant des motifs topographiques (i.e. en saillie) 121 est pressé contre le substrat 100 recouvert de la couche de polymère 110, et plus particulièrement contre la partie non-greffée 110b de la couche de polymère 110. Chaque motif en creux 111 dans la partie non-greffée 110b correspond à l'empreinte laissée par un motif topographique 121 du moule 120. La pression exercée et la hauteur des motifs topographiques 121 sont telles que les motifs 121 du moule ne rentrent pas en contact avec la partie greffée 110a de la couche de polymère 110. Une couche résiduelle 110c du polymère de fonctionnalisation 110 peut alors être observée en fond des motifs en creux 111. Les motifs en creux 111 ont de préférence une profondeur comprise entre 5 nm et 20 nm, alors que la partie non-greffée 110b mesure entre 10 nm et 50 nm d'épaisseur.

Lors de l'étape d'impression S13, on applique de préférence le principe de conservation du volume local : le matériau polymère non-greffé est juste déplacé et ne diminue pas en quantité. Pour cela, l'épaisseur de la couche de polymère 110 est choisie de sorte que le volume de la partie non-greffée 110b soit supérieur au volume à remplir dans les cavités du moule 120 (i.e. de chaque côté des motifs topographiques 121).

Dans ce premier mode de mise en œuvre du procédé, l'impression est avantageusement assistée thermiquement, en chauffant le substrat et/ou le moule à une température supérieure à la température de transition vitreuse du polymère de fonctionnalisation 110, généralement comprise entre 100 °C et 120 °C pour les copolymères à base de PMMA et PS. Puis, une pression comprise entre 1 bar (0,1 MPa) et 100 bars (10 MPa) est appliquée en face arrière du moule 120 pendant quelques minutes. Enfin, l'ensemble moule-substrat est refroidi à une température inférieure à la température de transition vitreuse du matériau polymère, avant que le moule 120 ne soit séparé du substrat 100.

L'étape S14 qui suit (cf. Fig.1D) consiste à transférer les motifs en creux 111 formés dans la partie non-greffée 110b vers la partie greffée 110a de la couche de polymère 110, et ce jusqu'à déboucher sur la face supérieure du substrat 100. Autrement dit, lors de cette étape S14, on élimine la couche résiduelle 110c de polymère située au fond des motifs en creux 111.

Ce transfert est obtenu en gravant la partie greffée 110a de la couche de polymère au travers de la partie non-greffée 110b, qui sert donc de masque de gravure. L'épaisseur de la partie greffée 110a étant bien inférieure à celle de la partie non-greffée 110b, la couche résiduelle 110c peut être éliminée entièrement tout en conservant une épaisseur de polymère non-greffé sur la partie greffée 110a.

Un procédé de gravure sèche, de type plasma, par exemple à base d'oxygène et de gaz chloré et/ou fluoré, peut être employé à l'étape S14 de transfert. Ce type de gravure est fortement anisotrope et permet donc d'obtenir des motifs en creux 111' dans la partie greffée 110a de même largeur que les motifs en creux 111 dans la partie non-greffée 110b. Dans la mesure où elle est recouverte la partie non-greffée 110b pendant toute l'étape S14, la partie greffée 110a de la couche de polymère 110 n'est pas exposée au plasma et ne risque donc pas d'être altérée par celui-ci.

Ainsi, dans ce premier mode de mise en œuvre, la partie non-greffée 110b constitue une couche protectrice de la partie greffée 110a du polymère de fonctionnalisation. La partie greffée 110a étant destinée à former la couche de fonctionnalisation du substrat 100, cela permet de préserver ses propriétés physiques et chimiques, telles que la rugosité et l'affinité chimique. Cette protection agit aussi bien pendant l'étape d'impression des motifs que pendant l'étape ultérieure de transfert de ces motifs (étape de structuration de la couche de fonctionnalisation proprement dite).

La partie non-greffée 110b de la couche de polymère 110 peut être également qualifiée de couche sacrificielle puisqu'elle est éliminée, lors d'une étape S15 représentée par la figure 1E, pour découvrir la partie greffée 110a. On obtient ainsi une couche de fonctionnalisation, structurée, c'est-à-dire qui expose une ou plusieurs zones de la face supérieure du substrat 100 (dans les motifs en creux 111'). Cette élimination est effectuée par gravure humide, afin de ne pas altérer les propriétés de la couche de fonctionnalisation. De préférence, un solvant tel que le PGMEA est utilisé pour dissoudre la partie non-greffée 110b du polymère de fonctionnalisation.

Une spécificité de ce premier mode de mise en œuvre du procédé de fonctionnalisation est que les motifs sont imprimés directement dans la partie non-greffée 110b de la couche de polymère 110. Cela permet de minimiser le nombre d'étapes du procédé de fonctionnalisation, ainsi que le nombre de matériaux utilisés.

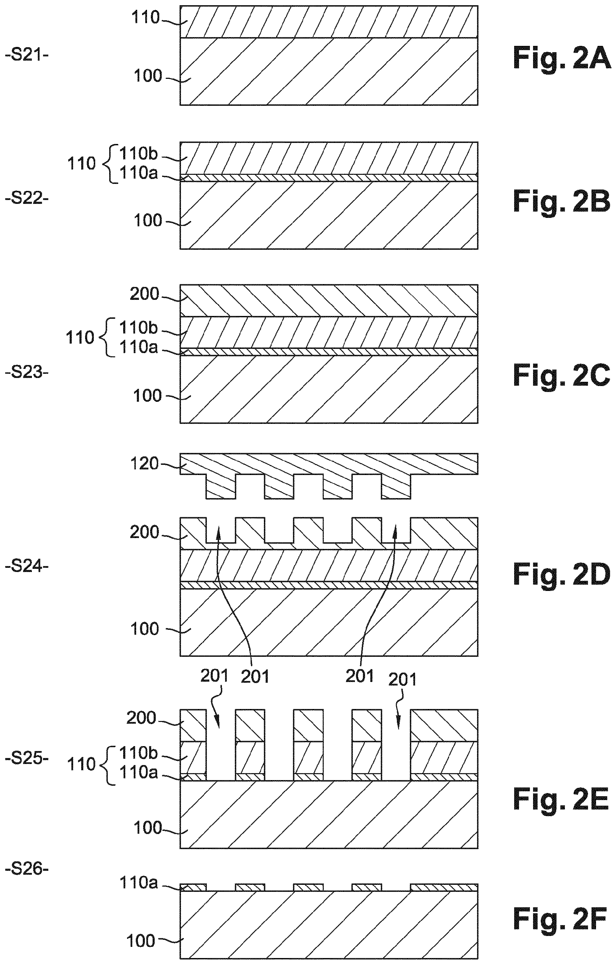

Les figures 2A à 2F représentent des étapes S21 à S26 d'un procédé de fonctionnalisation selon un deuxième mode de mise en œuvre de l'invention.

Les deux premières étapes S21 et S22, illustrées par les figures 2A et 2B respectivement, sont identiques aux étapes S11 et S12 décrites précédemment en relation avec les figures 1A et 1B. Ainsi, une couche d'un polymère de fonctionnalisation 110 est déposée sur le substrat 100 au cours de l'étape S21, puis une partie 110a de cette couche est greffée au substrat 100 lors de l'étape S22. Comme précédemment, une partie non-greffée 110b de la couche de polymère 110 recouvre la partie greffée 110a.

En référence à la figure 2C, le procédé de fonctionnalisation comprend ensuite une étape S23 consistant à déposer une couche en un matériau polymère imprimable 200 sur la partie non-greffée 110b de la couche de polymère 110. Ce polymère imprimable 200 est distinct du polymère de fonctionnalisation 110. Le polymère imprimable 200 est de préférence une résine thermoplastique, par exemple à base de PS, de PMMA ou de copolymère de cyclooléfine (COC), une résine thermodurcissable (ex. résine à base acrylique comprenant un agent de réticulant amorcé thermiquement) ou une résine photo-polymérisable (ex. résine à base époxy ou acrylate comprenant un ou plusieurs photo-initiateurs).

Puis, à l'étape S24 de la figure 2D, des motifs 201 sont imprimés dans la couche de polymère imprimable 200 à l'aide d'un moule 120. Lorsque le polymère imprimable 200 est une résine thermoplastique ou thermodurcissable, l'impression est assistée thermiquement. Le polymère imprimable 200 est chauffé à une température de réticulation (dans le cas d'une résine thermodurcissable) ou à une température de transition vitreuse (dans le cas d'une résine thermoplastique). Cette température de réticulation ou de transition vitreuse (selon le cas) est avantageusement inférieure à la température de transition vitreuse du polymère de fonctionnalisation 110 (par exemple un copolymère statistique). On évite ainsi de rendre déformable le polymère de fonctionnalisation 110 et, par conséquent, le risque de mélanger les polymères.

Dans une variante de mise en œuvre de l'étape S24, lorsque le polymère imprimable 200 est une résine photo-polymérisable, l'impression est assistée par ultraviolets (UV). La couche de polymère imprimable 200 est exposée à des rayons UV pendant que le moule 120 est pressé contre le substrat 100. Le moule 120 est alors transparent aux rayons UV. L'impression assistée par UV peut être effectuée à température ambiante (i.e. 25°C) ou à une température comprise entre 40 °C et 70 °C (et donc à une température inférieure à la température de transition vitreuse du polymère de fonctionnalisation 110). La pression appliquée est de préférence comprise entre 1 bar (0,1 MPa) et 50 bars (5 MPa). La résine est ainsi insolée pendant plusieurs minutes, jusqu'à obtenir son durcissement. Enfin, le moule 120 est séparé de la couche de résine durcie.

Utiliser un matériau polymère imprimable distinct du polymère de fonctionnalisation permet d'optimiser l'étape S24 d'impression des motifs, car ce matériau peut alors être choisi pour ses propriétés de mise en forme (par impression), indépendamment du choix du polymère de fonctionnalisation. Cette différenciation des matériaux offre également plus de possibilités pour le choix du polymère de fonctionnalisation. En effet, le polymère de fonctionnalisation n'a pas besoin d'être imprimable dans ce deuxième mode de mise en œuvre.

Le procédé de fonctionnalisation se poursuit par une étape S25 de transfert des motifs 201 (Fig.2E), semblable à celle décrite en référence à la figure 1D. Les motifs 201 imprimés dans la couche de polymère imprimable 200 sont transférés dans la partie non-greffée 110b, puis dans la partie greffée 110a de la couche de polymère 110 jusqu'à atteindre le substrat 100. Ce transfert est de préférence obtenu par gravure plasma à travers la couche de polymère imprimable 200 et la partie non-greffée 110b.

Ainsi, dans ce deuxième mode de mise en œuvre du procédé de fonctionnalisation, la couche sacrificielle qui protège la partie greffée 110a lors du transfert des motifs (201) comporte une première sous-couche correspondant à la partie non-greffée 110b de la couche de polymère 110 et une deuxième sous-couche constituée du polymère imprimable 200.

Enfin, lors d'une dernière étape S26 illustrée par la figure 2F, on élimine au moyen d'un solvant la partie non-greffée 110b de la couche de polymère 110, ce qui permet de retirer simultanément la couche de polymère imprimable 200 (soit par effet de soulèvement, ou effet « lift-off », lorsqu'il s'agit d'un matériau thermodurcissable ou photo-polymérisable, soit par l'effet du solvant lui-même, lorsqu'il s'agit d'un matériau thermoplastique). Alternativement, la couche de polymère imprimable 200 est d'abord éliminée par gravure sèche, par exemple au moyen d'un plasma (ex. O₂, Cl₂, C₄F₈ et leurs combinaisons), puis la partie non-greffée 110b de la couche de polymère 110 est éliminée par gravure humide (de préférence au moyen d'un solvant). Cette dernière étape permet de découvrir la partie non-greffée 110a du polymère de fonctionnalisation, qui recouvre le substrat 100 sauf dans les zones correspondant à l'emplacement des motifs imprimés 201.

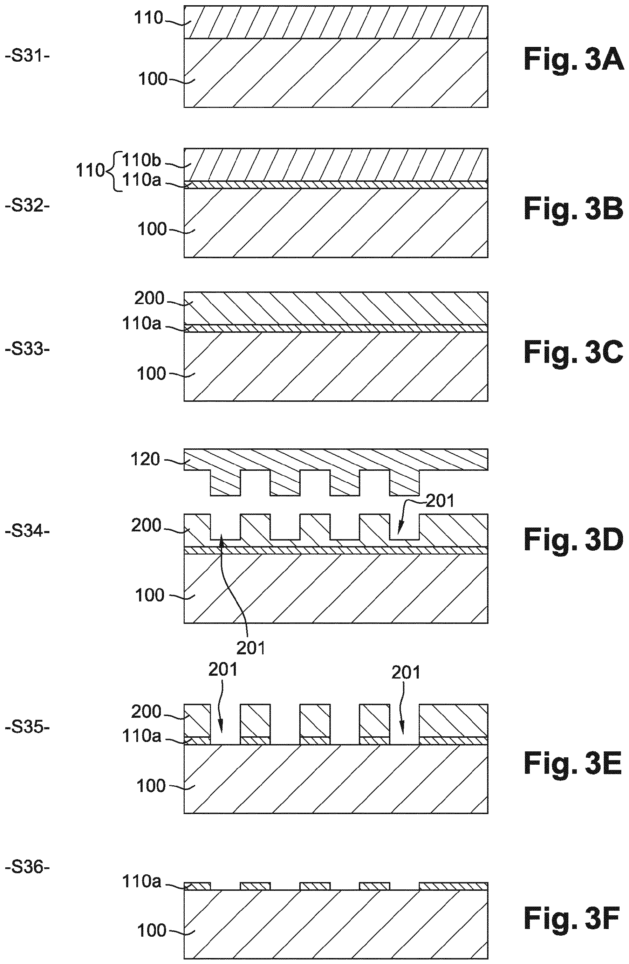

Les figures 3A à 3F représentent des étapes successives S31 à S36 d'un procédé de fonctionnalisation selon un troisième mode de mise en œuvre de l'invention.

Ce troisième mode de mise en œuvre diffère de celui des figures 2A-2F en ce que la partie non-greffée 110b de la couche de polymère 110 est retirée avant le dépôt de la couche de polymère imprimable 200, au cours d'une étape S33 (Fig.3C).

Ainsi, la couche protectrice (et sacrificielle) qui recouvre la partie greffée 110a du polymère de fonctionnalisation est constituée uniquement de la couche de polymère imprimable 200. On évite ainsi la superposition de deux matériaux polymère - le polymère de fonctionnalisation non-greffé et le polymère imprimable - et donc les problèmes de compatibilité qui résultent de cette superposition.

Outre le bénéfice apporté par le matériau imprimable 200 (i.e. simplification de l'étape d'impression), ce troisième mode de mise en œuvre offre la plus grande liberté quant aux choix des polymères. En effet, le polymère de fonctionnalisation est, une fois greffé, stable chimiquement et thermiquement et ne limite donc pas le choix du polymère imprimable 200 déposé par-dessus.

Les autres étapes du procédé, c'est-à-dire l'étape de dépôt S31 du polymère de fonctionnalisation 110, l'étape de greffage S32, l'étape d'impression S34 des motifs 201 dans la couche de polymère imprimable 200, l'étape de transfert S35 des motifs 201 et l'étape de retrait S35 de la couche protectrice, sont mises en œuvre comme décrit précédemment en relation avec les figures 2A-2B, 2D-2F (étapes S21-S22, S24-S26 respectivement). En particulier, un solvant tel que celui utilisé pour retirer la partie non-greffée 110b (ex. PGMEA) ou un autre solvant polaire aprotique est avantageusement utilisé à l'étape S36 pour retirer la couche protectrice en polymère imprimable 200.

Le substrat fonctionnalisé obtenu à l'issu de l'un quelconque des procédés ci-dessus (cf. Figs.1E, 2F et 3F) peut être utilisé dans un procédé d'auto-assemblage dirigé de copolymère à blocs (« Directed Self-Assembly », DSA), et plus particulièrement dans un procédé de chémo-épitaxie, afin de générer des motifs de très hautes résolution et densité. Ce procédé de chémo-épitaxie comporte une étape de dépôt d'un copolymère à blocs à la surface du substrat fonctionnalisé (sur la partie greffée 110a du polymère de fonctionnalisation) et une étape d'organisation des blocs du copolymère, par exemple par recuit.

Le copolymère à blocs peut notamment être choisi parmi les suivants :
- PS-*b*-PMMA : polystyrène-bloc-polyméthylméthacrylate ;
- PS-*b*-PLA : polystyrène-bloc-acide polylactique ;
- PS-*b*-PEO : polystyrène-bloc-polyoxyde d'éthylène ;
- PS-*b*-PDMS : polystyrène-bloc-polydiméthylsiloxane ;
- PS-*b*-PMMA-b-PEO : polystyrène-bloc-polyméthylméthacrylate-bloc-polyoxyde d'éthylène ;
- PS-*b*-P2VP : polystyrène-bloc-poly(2vinylpyridine).

Le polymère de fonctionnalisation 110 peut être un copolymère statistique composé des mêmes blocs de monomère que les copolymères à blocs listés ci-dessus (PS-*r-*PMMA, PS-*r*-PLA, PS-*r*-PEO...), un homopolymère constitué de l'un de ces monomères (PS, PMMA, PLA...) ou tout autre polymère greffable et présentant l'affinité souhaitée. Les matériaux comprenant du PS, du PMMA et/ou du PDMS ont la particularité de pouvoir être imprimés thermiquement (cf. Fig.1C).

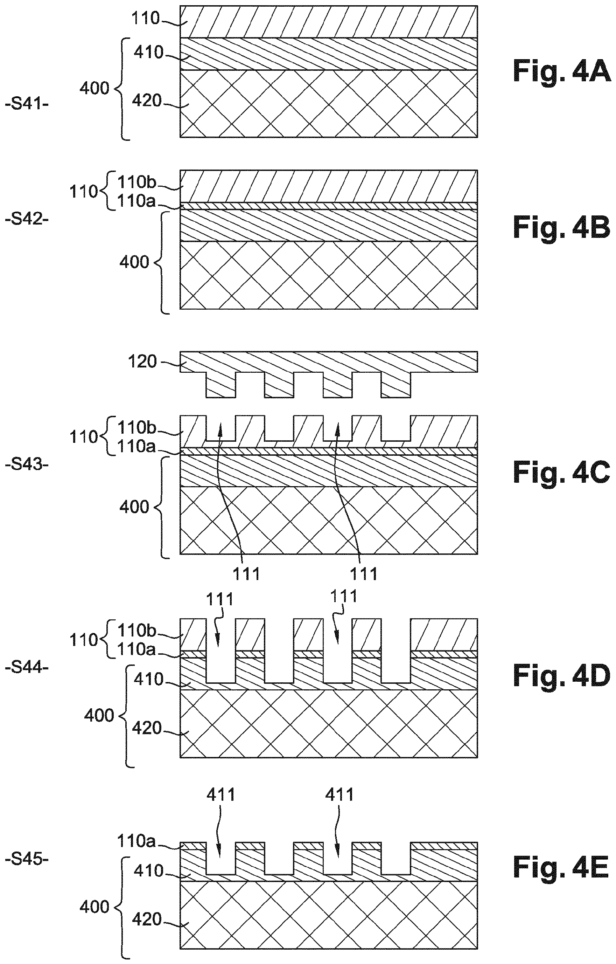

Un quatrième mode de mise en œuvre du procédé de fonctionnalisation selon l'invention va maintenant être décrit en référence aux figures 4A à 4E. Celui-ci est dérivé du premier mode de mise en œuvre, dans lequel les motifs sont imprimés directement dans une partie non-greffée du polymère de fonctionnalisation.

Le procédé de fonctionnalisation des figures 4A à 4E comprend ainsi une étape S41 consistant à déposer une couche d'un premier polymère de fonctionnalisation 110 sur un substrat 400 (cf. Fig.4A), une étape de greffage S42 d'une partie 110a de cette couche à la surface du substrat 400 (Fig.4B), une étape S43 d'impression de motifs 111 dans la partie non-greffée 110b de la couche du premier matériau de fonctionnalisation 110 (Fig.4C), une étape de transfert des motifs 111 dans la partie greffée 110a (Fig.4D), et enfin une étape d'élimination de la partie non-greffée 110b par gravure humide (Fig.4E).

Les spécificités de ce quatrième mode de mise en œuvre du procédé de fonctionnalisation sont au nombre de deux.

Premièrement, le substrat 400 à fonctionnaliser comporte une couche superficielle 410 en un deuxième matériau polymère de fonctionnalisation. Ce deuxième polymère de fonctionnalisation présente une affinité chimique différente de celle du premier polymère de fonctionnalisation 110, déposé sur le substrat 400 à l'étape S41 de la figure 4A. Ainsi, lorsque le premier polymère de fonctionnalisation 110 est neutre vis-à-vis du copolymère à blocs, le deuxième polymère de fonctionnalisation présente une affinité préférentielle pour l'un des blocs du copolymère. Le deuxième polymère de fonctionnalisation est de préférence un homopolymère, tel que le polystyrène (PS). La couche superficielle 410, d'épaisseur comprise entre 1 nm et 500 nm, est disposée sur une couche de support 420 du substrat 400, par exemple en silicium.

Deuxièmement, les motifs 111 imprimés dans la partie non-greffée 110b sont transférés au-delà de la partie greffée 110a lors de l'étape de gravure plasma S44, pour former des motifs en creux 411 dans une partie au moins de la couche superficielle 410. De préférence, les motifs en creux 411 ont une profondeur comprise entre 5 nm et 20 nm. Ils n'atteignent donc pas la couche de support 420 en silicium.

Ainsi, à l'issue de ce procédé de fonctionnalisation (cf. Fig.4E), on obtient non seulement un contraste chimique à la surface du substrat 400, formé par l'alternance entre la couche du premier polymère de fonctionnalisation 110 et la couche superficielle 410 en deuxième polymère de fonctionnalisation, mais également un contraste topographique dû aux motifs en creux 411 formés dans la couche superficielle 410.

Un tel substrat fonctionnalisé peut notamment servir à un procédé hybride mêlant chémo-épitaxie et grapho-épitaxie. Les motifs en creux 411 constituent en effet un guide d'assemblage qui sera rempli par le copolymère à blocs et qui permettra de contrôler, en sus de la couche de fonctionnalisation (110a), l'organisation des blocs du copolymère.

Dans une variante de mise en œuvre de l'étape S44 (Fig.4D), les motifs en creux 411 formés dans la couche superficielle 410 débouchent sur la face supérieure de la couche de support 420 et le matériau de cette couche de support 420 (par exemple du SiO₂ qui est PMMA-affine) présente une affinité chimique vis-à-vis du copolymère à blocs différente de celles des premier et deuxième polymères de fonctionnalisation. Cela permet d'obtenir un guide d'assemblage présentant de multiples affinités chimiques : une première affinité chimique au niveau de la face supérieure du guide (partie greffée 110a), une deuxième affinité chimique au niveau des parois latérales des motifs de guidage 411 (couche superficielle 410) et une troisième affinité chimique au fond des motifs de guidage 411 (couche de support 420).

La formation d'un guide d'assemblage dans la couche superficielle 410 du substrat 400 est compatible également avec les deuxième et troisième modes de mise en œuvre du procédé de fonctionnalisation, représentés respectivement par les figures 2A-2F et 3A-3F. Ainsi, pour imprimer les motifs, on peut également utiliser un matériau polymère imprimable spécifique, en superposition (Figs.2A-2F) ou en substitution (Figs.3A-3F) de la partie non-greffée du premier polymère de fonctionnalisation 110.

Naturellement, le procédé de fonctionnalisation selon l'invention n'est pas limité aux modes de réalisation décrits en référence aux figures 1 à 4 et de nombreuses variantes et modifications apparaîtront à l'homme du métier. En particulier, le premier polymère de fonctionnalisation (110) et le deuxième polymère de fonctionnalisation (410) pourraient présenter d'autres compositions que celles décrites précédemment. De même, d'autres copolymères à blocs pourraient être utilisés.

Dans une variante de mise en œuvre du procédé, le greffage de la couche de polymère sur le substrat est obtenu lors de l'étape d'impression. En effet, puisque l'impression est assistée thermiquement, l'ensemble de la couche de polymère est chauffée et une partie non imprimée peut être greffée au substrat. Autrement dit, l'étape de greffage S12, S22, ou S42 et l'étape d'impression S13, S24, ou S43 peuvent être accomplies simultanément, plutôt que successivement.

## Revendications

1. Procédé de fonctionnalisation d'un substrat (100, 400) destiné à l'auto-assemblage d'un copolymère à blocs, comprenant les étapes suivantes :
- déposer (S11, S21, S31, S41) à la surface d'un substrat (100, 400) une couche d'un premier matériau polymère (110), le premier polymère présentant une première affinité chimique vis-à-vis du copolymère à blocs ;
**caractérisé en ce qu'**il comprend les étapes suivantes :
- greffer (S12, S22, S32, S42) une partie (110a) seulement de la couche de premier matériau polymère (110) à la surface du substrat (100, 400) ;
- imprimer (S13, S24, S34, S43), à l'aide d'un moule (120), des motifs (111, 201) dans une couche sacrificielle disposée au-dessus de la partie greffée (110a) de la couche de premier matériau polymère (110) ;
- transférer (S14, S25, S35, S44) les motifs de la couche sacrificielle dans la partie greffée (110a) de la couche de premier matériau polymère (110), jusqu'à atteindre le substrat (100, 400) ; et
- éliminer (S15, S26, S36, S45) au moins une partie de la couche sacrificielle par gravure humide, de façon à découvrir la partie greffée (110a) de la couche de premier matériau polymère (110).

2. Procédé selon la revendication 1, dans lequel la couche sacrificielle est constituée par une partie non-greffée (110b) de la couche de premier matériau polymère (110).

3. Procédé selon la revendication 1, dans lequel la couche sacrificielle est constituée d'un matériau polymère imprimable distinct du premier matériau polymère.

4. Procédé selon la revendication 3, comprenant une étape (S33) consistant à éliminer une partie non-greffée (110b) de la couche de premier matériau polymère (110), puis à déposer la couche sacrificielle en matériau polymère imprimable (200) sur la partie greffée (110a) de la couche de premier matériau polymère (110).

5. Procédé selon la revendication 1, dans lequel la couche sacrificielle comporte une première sous-couche constituée par une partie non-greffée (110b) de la couche de premier matériau polymère (110) et une deuxième sous-couche en un matériau polymère imprimable (200) distinct du premier matériau polymère, ladite au moins une partie de la couche sacrificielle éliminée par gravure humide correspondant à la première sous-couche.

6. Procédé selon la revendication 5, comprenant une étape (S23) de dépôt de la couche sacrificielle en matériau polymère imprimable (200) sur la partie non-greffée (110b) de la couche de premier matériau polymère (110).

7. Procédé selon l'une quelconque des revendications 3 à 6, dans lequel le matériau polymère imprimable (200) est une résine thermoplastique, une résine thermodurcissable ou une résine photo-polymérisable.

8. Procédé selon l'une quelconque des revendications 1 à 7, dans lequel le substrat (400) comporte une couche superficielle (410) en un deuxième matériau polymère présentant une deuxième affinité chimique vis-à-vis du copolymère à blocs et dans lequel les motifs (111) de la couche sacrificielle sont en outre transférés dans la couche superficielle (410).

9. Procédé selon la revendication 8, dans lequel le deuxième matériau polymère présente une affinité préférentielle pour l'un des blocs du copolymère à blocs.

10. Procédé selon l'une quelconque des revendications 1 à 9, dans lequel ladite au moins une partie de la couche sacrificielle est éliminée au moyen d'un solvant.

11. Procédé selon l'une quelconque des revendications 1 à 10, dans lequel le premier matériau polymère (110) est neutre par rapport aux blocs du copolymère à blocs.

12. Procédé selon l'une quelconque des revendications 1 à 11, dans lequel la couche de premier matériau polymère (110) est formée d'un copolymère statistique, d'un homopolymère ou d'une monocouche auto-assemblée.

13. Procédé selon l'une quelconque des revendications 1 à 12, dans lequel les motifs (111, 201) sont imprimés dans la couche sacrificielle par impression thermique ou par impression assistée par ultraviolets.

14. Procédé selon l'une quelconque des revendications 1 à 13, dans lequel le greffage (S12, S22, S42) de la couche de premier matériau polymère (110) à la surface du substrat (100, 400) s'effectue en même temps que l'impression (S13, S24, S43) des motifs.

15. Procédé de chémo-épitaxie comprenant :
- la préparation d'un substrat fonctionnalisé à l'aide d'un procédé selon l'une quelconque des revendications 1 à 14 ;
- le dépôt d'un copolymère à blocs à la surface du substrat fonctionnalisé ; et
- l'assemblage du copolymère à blocs.

## Patentansprüche

1. Funktionalisierungsverfahren eines Substrats (100, 400), das zur Selbstassemblierung eines Block-Kopolymers bestimmt ist, umfassend die folgenden Schritte:
- Aufbringen (S11, S21, S31, S41) einer Schicht eines ersten Polymermaterials (110) auf die Oberfläche eines Substrats (100, 400), wobei das erste Polymer eine erste chemische Affinität gegenüber dem Block-Kopolymer aufweist;
**dadurch gekennzeichnet, dass** es die folgenden Schritte umfasst:
- Aufpfropfen (S12, S22, S32, S42) nur eines Teils (110a) der Schicht aus erstem Polymermaterial (110) auf die Oberfläche des Substrats (100, 400);
- Aufdrucken (S12, S24, S34, S43) von Mustern (111, 201) mithilfe einer Form (120) in eine Opferschicht, die oberhalb des aufgepfropften Teils (110a) der Schicht aus erstem Polymermaterial (110) angeordnet ist;
- Übertragen (S14, S25, S35, S44) der Muster der Opferschicht in den aufgepfropften Teil (110a) der Schicht aus erstem Polymermaterial (110), bis das Substrat (100, 400) erhalten wird; und
- Austragen (S15, S26, S36, S45) wenigstens eines Teils der Opferschicht per Feuchtgravur derart, dass der aufgepfropfte Teil (110a) der Schicht aus erstem Polymermaterial (110) freigelegt wird.

2. Verfahren gemäß Anspruch 1, bei dem die Opferschicht durch einen nicht aufgepfropften Teil (110b) der Schicht aus erstem Polymermaterial (110) gebildet wird.

3. Verfahren gemäß Anspruch 1, bei dem die Opferschicht aus einem von dem ersten Polymermaterial unterschiedlichen bedruckbaren Polymermaterial gebildet wird.

4. Verfahren gemäß Anspruch 3, umfassend einen Schritt (S33) bestehend aus dem Austragen eines nicht aufgepfropften Teils (110b) der Schicht des ersten Polymermaterials (110), dann dem Aufbringen der Opferschicht aus bedruckbarem Polymermaterial (200) auf dem aufgepfropften Teil (110a) der Schicht aus erstem Polymermaterial (110).

5. Verfahren gemäß Anspruch 1, bei dem die Opferschicht eine erste Teilschicht umfasst, die aus einem nicht aufgepfropften Teil (110b) der Schicht aus erstem Polymermaterial (110) und einer zweiten Teilschicht aus einem bedruckbaren Polymermaterial (200) gebildet wird, das von dem ersten Polymermaterial unterschiedlich ist, wobei der genannte wenigstens eine Teil der Opferschicht, der per Feuchtgravur ausgetragen wird, der ersten Teilschicht entspricht.

6. Verfahren gemäß Anspruch 5, umfassend einen Aufbringschritt (S23) der Opferschicht aus bedruckbarem Polymermaterial (200) auf dem nicht aufgepfropften Teil (110b) der Schicht aus erstem Polymermaterial (110).

7. Verfahren gemäß irgendeinem der Ansprüche 3 bis 6, bei dem das bedruckbare Polymermaterial (200) aus einem thermoplastischen Harz, einem wärmeaushärtenden Harz oder einem photopolymerisierbaren Harz ist.

8. Verfahren gemäß irgendeinem der Ansprüche 1 bis 7, bei dem das Substrat (400) eine oberflächliche Schicht (410) aus einem zweiten Polymermaterial umfasst, das eine zweite chemische Affinität gegenüber dem Blockpolymer aufweist und in dem die Muster (111) der Opferschicht darüber hinaus in die oberflächliche Schicht (410) übertragen werden.

9. Verfahren gemäß Anspruch 8, bei dem das zweite Polymermaterial eine bevorzugte Affinität für einen der Blöcke des Block-Kopolymers aufweist.

10. Verfahren gemäß irgendeinem der Ansprüche 1 bis 9, bei dem der genannte wenigstens eine Teil der Opferschicht mittels eines Lösungsmittels ausgetragen wird.

11. Verfahren gemäß irgendeinem der Ansprüche 1 bis 10, bei dem das erste Polymermaterial (110) in Bezug auf die Blöcke des Block-Kopolymers neutral ist.

12. Verfahren gemäß irgendeinem der Ansprüche 1 bis 11, bei dem die Schicht aus erstem Polymermaterial (110) aus einem statistischen Kopolymer, einem Homopolymer oder einer selbstmontierten Monoschicht gebildet wird.

13. Verfahren gemäß irgendeinem der Ansprüche 1 bis 12, bei dem die Muster (111, 201) in der Opferschicht per thermischem Aufdrucken oder per Ultraschall unterstütztem Druck aufgedruckt werden.

14. Verfahren gemäß irgendeinem der Ansprüche 1 bis 13, bei dem das Aufpfropfen (S12, S22, S42) der Schicht aus erstem Polymermaterial (110) auf die Oberfläche des Substrats (100, 400) gleichzeitig mit dem Aufdrucken (S13, S24, S43) der Muster erfolgt.

15. Chemo-Epitaxieverfahren, umfassend:
- die Vorbereitung eines funktionalisierten Substrats mithilfe eines Verfahrens gemäß irgendeinem der Ansprüche 1 bis 14;
- das Aufbringen eines Block-Kopolymers auf der Oberfläche des funktionalisierten Substrats; und;
- das Assemblieren des Block-Kopolymers.

## Claims

1. Method for functionalising a substrate (100, 400) intended for the self-assembly of a block copolymer, comprising the following steps:
- depositing (S11, S21, S31, S41) on the surface of a substrate (100, 400) a layer of a first polymer material (110), the first polymer having a first chemical affinity with respect to the block copolymer;
**characterised in that** it comprises the following steps:
- grafting (S12, S22, S32, S42) one part (110a) only of the first polymer material layer (110) onto the surface of the substrate (100, 400);
- printing (S13, S24, S34, S43), using a mould (120), patterns (111, 201) in a sacrificial layer arranged above the grafted part (110a) of the first polymer material layer (110);
- transferring (S14, S25, S35, S44) the patterns of the sacrificial layer into the grafted part (110a) of the first polymer material layer (110), until the substrate is reached (100, 400); and
- removing (S15, S26, S36, S45) at least one part of the sacrificial layer by wet etching, so as to uncover the grafted part (110a) of the first polymer material layer (110).

2. Method according to claim 1, wherein the sacrificial layer is comprised of a non-grafted part (110b) of the first polymer material layer (110).

3. Method according to claim 1, wherein the sacrificial layer is comprised of a printable polymer material distinct from the first polymer material.

4. Method according to claim 3, comprising a step (S33) consisting in removing a non-grafted part (110b) of the first polymer material layer (110), then in depositing the sacrificial layer made of printable polymer material (200) on the grafted part (110a) of the first polymer material layer (110).

5. Method according to claim 1, wherein the sacrificial layer comprises a first sub-layer comprised of a non-grafted part (110b) of the first polymer material layer (110) and a second sub-layer made of a printable polymer material (200) distinct from the first polymer material, said at least one part of the sacrificial layer removed by wet etching corresponding to the first sub-layer.

6. Method according to claim 5, comprising a step (S23) of depositing the sacrificial layer made of printable polymer material (200) on the non-grafted part (110b) of the first polymer material layer (110).

7. Method according to any of claims 3 to 6, wherein the printable polymer material (200) is a thermoplastic resin, a thermosetting resin or a photo-polymerisable resin.

8. Method according to any of claims 1 to 7, wherein the substrate (400) comprises a superficial layer (410) made of a second polymer material having a second chemical affinity with respect to the block copolymer and wherein the patterns (111) of the sacrificial layer are further transferred into the superficial layer (410).

9. Method according to claim 8, wherein the second polymer material has a preferential affinity for one of the blocks of the block copolymer.

10. Method according to any of claims 1 to 9, wherein said at least one part of the sacrificial layer is removed by means of a solvent.

11. Method according to any of claims 1 to 10, wherein the first polymer material (110) is neutral with respect to the blocks of the block copolymer.

12. Method according to any of claims 1 to 11, wherein the first polymer material layer (110) is formed of a random copolymer, a homopolymer or a self-assembled monolayer.

13. Method according to any of claims 1 to 12, wherein the patterns (111, 201) are printed in the sacrificial layer by thermal printing or by UV-enhanced printing.

14. Method according to any of claims 1 to 13, wherein the grafting (S12, S22, S42) of the first polymer material layer (110) onto the surface of the substrate (100, 400) is carried out at the same time as the printing (S13, S24, S43) of the patterns.

15. Chemo-epitaxy method comprising:
- the preparation of a substrate functionalised using a method according to any of claims 1 to 14;
- the deposition of a block copolymer on the surface of the functionalised substrate; and
- the assembly of the block copolymer.
